# EUROPEAN PATENT APPLICATION

(11) **EP 2 806 311 A1**
(43) Date of publication of application: **26.11.2014**
(21) Application number: 14169564.3
(22) Date of filing: 23.05.2014
(51) Int. Cl.: G03F 7/20, H01L 21/687

(54) **Wafer chuck**

(30) Priority: 24.05.2013 KR 20130058972
(71) Applicant: Systech Co. Ltd., Gyeonggi-do 445-929 (KR)
(72) Inventor: Jung, Byung Hyo, 445-774 Gyeonggi-do (KR)
(74) Representative: Bockhorni & Kollegen

(57) **Abstract**

Disclosed is a wafer- or flat glass-chuck (1) for a stepper useful for lithography. The wafer- or flat glass-chuck for use in photolithography for fabricating a semiconductor device or an LCD or PDP comprises a plurality of regularly spaced, embossed, frusto-pyramidal dots (2) in a grid pattern thereon, with a vacuum hole (3) established in a central portion of every other dot. In the wafer- or flat glass sheet-chuck, the establishment of vacuum holes only in some of the plurality of dots can reduce the processing time and labor, compared to establishment in all dots, while guaranteeing an evacuation effect sufficient to hold the wafer or flat glass sheet. In addition, frusto-pyramidal dots are advantageous in terms of processing time and cost, compared to cylindrical dots

## Description

### BACKGROUND OF THE INVENTION

### 1. Field of the Invention

The present invention relates to a wafer- or flat glass-chuck for a stepper useful for lithography. More particularly, the present invention relates to a wafer- or flat glass-chuck for a stepper, comprising a plurality of frusto-pyramidal, embossed dots formed thereon, with a suitable number of vacuum holes established in median portions of some of the dots, whereby a vacuum can be applied to the chuck precisely and rapidly enough to hold a wafer or a flat glass sheet

### 2. Description of the Related Art

On the whole, a photolithographic process is indispensable for the fabrication of semiconductor devices or LCDs (PDPs). This process is typically conducted using a stepper which is equipped with a chuck for immobilizing semiconductor wafers or LCD (PDP) flat glass sheets. In addition to immobilizing wafers and flat glass sheets during the fabrication, the chuck acts to keep the temperature of the wafer or flat glass sheet at a suitable temperature to establish an optimal process condition.

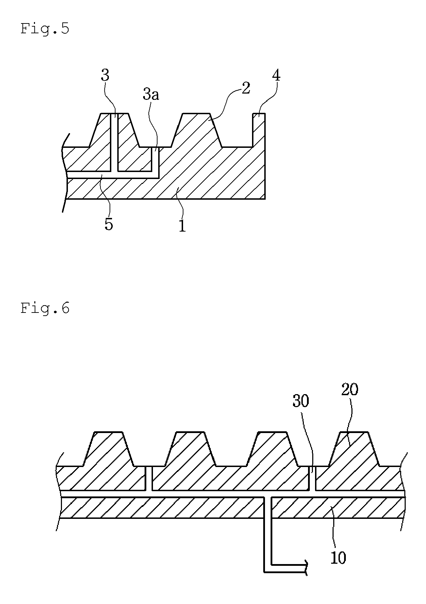

A partial structure of a conventional wafer- or glass-chuck, which is indispensible to a fabrication process of semiconductor or LCD (PDP) devices, is given in FIG. 6. As shown in FIG. 6, the wafer- or glass-chuck 10 in a circular or rectangular shape may have an array of dots 20 in an embossed pattern, formed by cutting the upper surface with a fine, surface grinder, and vacuum holes 30, formed in flat areas other than the dots 20 and communicating with a vacuum path, for holding wafers or flat glass sheets.

However, the contact area between the chuck and the wafer or glass sheet mounted on the chuck is entirely between the dots 20, and not the vacuum holes 30 formed on the flat area of the chuck. However, conventional chucks are disadvantageous in that their contact area with wafers or glass sheets is large, increasing the possibility of contaminating the wafers or flat glass sheets from the chuck, a fault fatal to the fabrication of semiconductor or LCD (PDP) devices. Another disadvantage of the conventional chuck is that it causes the wafer or flat glass sheet to bend between dots, giving rise to an increase of irregular exposed patterns, which leads to defective semiconductor or LCD (PDP) products.

Japanese Unexamined Patent Application Publication No. Hei 08-051143, herein referred to as patent document 1, discloses an apparatus for protecting and supporting a substrate in which all protrusions 5A in a cylindrical or frosto-conical form have vacuum holes 3 in the central portion thereof. In consideration of time and cost, the dots in a cylindrical or frosto-conical form are disadvantageous because the formation of cylindrical or frosto-conical dots on the chuck requires a long processing time, resulting in an increase in production cost.

In addition, the vacuum holes 3 are too abundant to be efficient because all the protrusions 5A have the vacuum holes therein. Further, the protrusions 5A have a height of 0.02 mm or less. During the transfer thereof, wafers or glass sheets may be partially broken to generate particles which are generally fine but may be larger than 0.02 mm. In this case, even when the wafer or glass particles fall on flat areas other than protrusions, the wafer or the flat glass sheet which is being mounted on the chuck is readily contacted and thus contaminated with the particles because they stand high above the protrusions, as described above.

### Prior Art Document

### Patent Document

(Patent Document 1) Japanese Unexamined Patent Application Publication No. Hei 08-051143

### SUMMARY OF THE INVENTION

Accordingly, the present invention has been made keeping in mind the above problems occurring in the prior art, and an object of the present invention is to provide a wafer- or flat glass-chuck for use in a stepper, comprising a plurality of regularly spaced, embossed, frusto-pyramidal dots in a grid pattern thereon, with a vacuum hole established in a central portion of every other dot, whereby a wafer or a flat glass sheet can be properly held on the dots, with a minimal contact between the wafer or flat glass sheet and the dots, partially thanks to the contact holes formed in the dots.

Another object of the present invention is to provide a wafer- or flat glass-chuck for use in a stepper, comprising a plurality of regularly spaced, embossed, frusto-pyramidal dots formed at a suitable height in a grid pattern thereon, whereby the wafer or the flat glass sheet, when mounted on the chuck, can be protected from damages and prevented from contamination.

In order to achieve the above objects, the present invention provides a wafer- or flat glass-chuck for use in a stepper, comprising a plurality of regularly spaced, embossed, frusto-pyramidal dots in a grid pattern thereon, with a vacuum hole established in a central portion of every other dot, said stepper being used in photoligraphy for fabricating a semiconductor device or an LCD or PDP.

In one embodiment of the wafer- or flat glass-chuck, each of the dots has a height of 0.05 ~ 0.29 mm.

In one embodiment of the wafer- or flat glass-chuck of claim, the vacuum hole is established in every dot.

In one embodiment of the wafer- or flat glass-chuck, vacuum holes are also established in some of the base regions between the dots, and a bank is formed along a brink of the chuck.

In the wafer- or flat glass sheet-chuck for use in a stepper in accordance with the present invention, the establishment of vacuum holes only in some of the plurality of dots can reduce the processing time and labor, compared to establishment in all dots, while guaranteeing an evacuation effect sufficient to hold a wafer or flat glass sheet. In addition, frusto-pyramidal dots are advantageous in terms of processing time and cost, compared to cylindrical dots. Further, the establishment of vacuum holes in only some of the dots can alleviate the warpage of the wafer or flat glass sheet which may be generated while it is held by the chuck.

Moreover, the chuck of the present invention can remarkably reduce the contamination of the held wafer or flat glass sheet with contaminants fatal to the fabrication of semiconductor devices or LCD (PDP) because it is much smaller in contact area with the wafer or flat glass sheet than a conventional chuck thanks to the vacuum holes established in the dots.

Also, because of being held by generating a vacuum within the chuck through the vacuum holes formed in the dots, wafers or flat glass sheets are less apt to bend.

Further, the dots are formed at a height which is experimentally set forth as being optimal for preventing the contamination of the wafer or flat glass sheet and for minimizing the warpage of the wafer or flat glass sheet.

In addition to stably hold a wafer or flat glass sheet, the chuck is designed to minimize a contact area with the wafer or flat glass sheet mounted thereon, thereby almost completely preventing the contamination of the wafer or flat glass sheet with particles and to have vacuum holes formed in the dots, thereby preventing the wafer or flat glass sheet from undergoing warpage.

### BREIF DESCRIPTION OF THE DRAWINGS

The above and other objects, features and other advantages of the present invention will be more clearly understood from the following detailed description taken in conjunction with the accompanying drawings, in which:
FIG. 1 is a plane view of a wafer- or glass-chuck for use in a stepper in accordance with a first embodiment of the present invention.
FIG. 2 is a partially enlarged plane view of the 'A' section of FIG. 1, according to the first embodiment of the present invention.
FIG. 3 is a partial, cross sectional view of the chuck according to the first embodiment of the present invention, taken along the B-B line of FIG. 1.
FIG. 4 is a partially enlarged plane view of the 'A' section of FIG. 1, according to a second embodiment of the present invention.
FIG. 5 is a cross sectional view of an end portion of the chuck according to a third embodiment of the present invention.
FIG. 6 is a lengthwise cross-sectional view of a conventional wafer- or flat glass-chuck.

### [Description of the Reference Numerals in the Drawings]

| | | | |
|---|---|---|---|
| 1, 1a : | Chuck | 2 : | Dot |
| 3 : | Vacuum hole formed in median portion of dot 2 | | |
| 3a : | Vacuum hole in the base region between dots 2 | | |
| 4 : | Bank | 5 : | Vacuum path |

### DESCRIPTION OF THE PREFERRED EMBODIMENTS

Below, a detailed description will be given of the wafer- or flat glass-chuck for use in a stepper with reference to the accompanying drawings. However, it should be understood that the present invention is not limited to the embodiments given below, but may be embodied in various modifications. The embodiments are offered to complete the disclosure of the present invention and to inform those skilled in the art of the scope of the present invention.

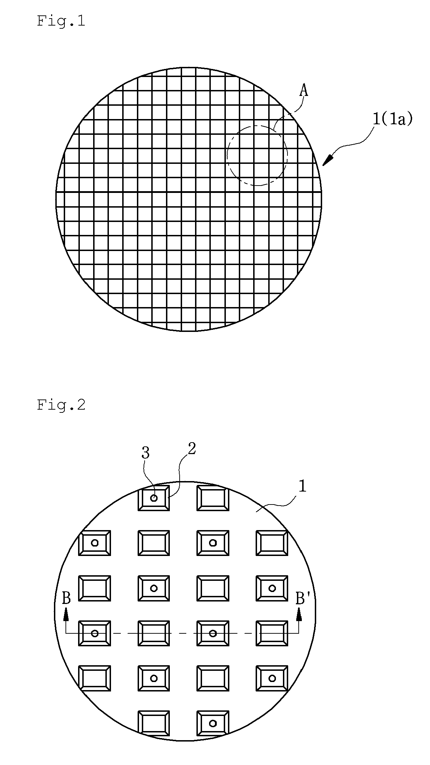

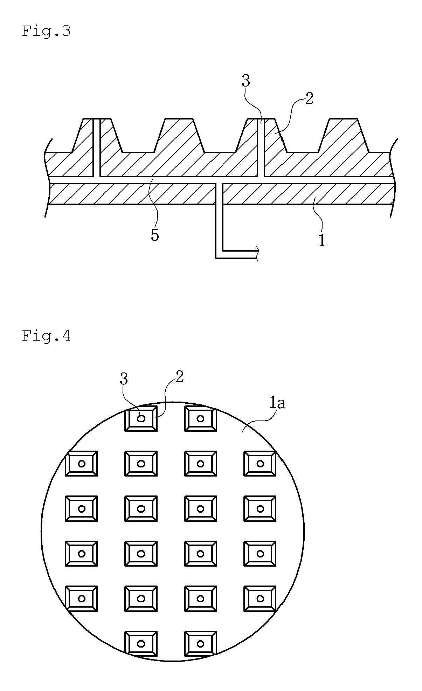

FIG. 1 is a plane view of a wafer- or glass-chuck for use in a stepper in accordance with a first embodiment of the present invention. FIG. 2 is a partially enlarged plane view of the `A' section of FIG. 1, according to the first embodiment of the present invention. FIG. 3 is a partial, cross sectional view of the chuck according to the first embodiment of the present invention, taken along the B-B line of FIG. 1.

As can be seen in FIGS. 1 to 3, the wafer- or glass-chuck 1 for use in a stepper according to a first embodiment of the present invention has a plurality of regularly spaced, embossed, frusto-pyramidal dots in a grid pattern thereon, with a vacuum hole 3 established in a central portion of every other dot 2, said vacuum hole 3 communicating with a vacuum path 5. That is, no vacuum holes are formed in a dot between dots 2 having vacuum holes 3 therein.

The dots 2 may be formed using a processing tool. For example, parts of a cylindrical or rectangular chuck substrate are ground in a widthwise straight direction and then in a lengthwise straight direction using a processing tool to a predetermined depth to form embossments on the surface of the chuck substrate. As the processing tool, an industrial tool is used to promote the processing of square pillar dots to frusto-pyramidal dots. In addition, some of the frusto-pyramidal dots are finely processed from the upper surface thereof to a predetermined depth using a high-speed tool to form a vacuum hole in a median portion thereof. Having a greater area of its lower plane section, each of the dots 2 in a frusto-pyramidal shape is stably formed within a relatively short time, which results in a reduction in process cost.

Since the vacuum hole 3 is formed in the median portion of each of some dots 2, when the wafer or flat glass sheet is mounted on the chuck 1, the contact area between the wafer or flat glass sheet and the dots 2 is reduced by the area of the vacuum holes 3. Although the vacuum holes are not formed in all, but in some of the dots 2, a vacuum generated within the chuck via the vacuum holes create a suction effect is sufficient to allow the chuck to hold the wafer or flat glass sheet. Further, the absence of vacuum holes in the dots between the dots where vacuum holes are formed is intended to prevent the warpage of the wafer or flat glass sheet lying on the dots.

Preferably, the dots 2 are 0.05~0.29 mm high. This height is set forth as being suitable to minimize the warpage which might occur when the wafer or flat glass sheet is held by the chuck via a vacuum. In addition, contaminants, if present on the chuck, may be confined to a size of at most 0.29 mm which does not have a substantially bad effect on the wafer or flat glass sheet. If the height of the dots 2 is below 0.04 mm, the wafer or flat glass sheet is apt to contact the base surface of the chuck. On the other hand, when the dots are taller than 0.3 mm, a greater vacuum intensity is needed to hold the wafer or flat glass sheet or it takes a longer time to generate a suitable vacuum within the chuck. In addition, a higher height of the dots may cause a severer warpage on the wafer or flat glass sheet on the dots, thus increasing the likelihood of photolithographic defectives.

To achieve the precise horizontality across the upper surface of the chuck 1 after completion of the formation of embossed frusto-pyramidal dots 2 and vacuum holes 3 therein, the upper surfaces of the dots 2 are polished by rotating the chuck in a uniform direction, with the chuck turned upside down.

A vacuum hole 3 must be processed in the median portion of each of the frusto-pyramidal dots so as to apply a vacuum rapidly and accurately thereacross, with care not to destroy the edge of the frusto-pyramidal dots.

Above all, the most important is the flatness across the chuck 1. In this regard, as described above, the chuck 2 is treated to polish the upper surfaces of the dots 2. A poor uniformity over the entire surface of the chuck 1 may incur the leakage of the vacuum generated within the chuck via the holes or may cause the wafer or flat glass sheet to undergo warpage, , leading to the formation of a non-accurate photographic pattern on the bent area upon exposure to light. Accordingly, defective products may result.

FIG. 4 is a partially enlarged plane view of the `A' section of FIG. 1, according to a second embodiment of the present invention.

As can be seen in FIG. 4, the chuck 1a according to the second embodiment of the present invention has a plurality of dots all of which are provided with a vacuum hole 3. The chuck 1a with more vacuum holes 3 may be used where a more intensive vacuum is needed. The chuck 1a is identical in structure and function to the chuck 1 according to the first embodiment, with the exception that all the dots are provided with vacuum holes 1.

With reference to FIG. 5, there is a cross sectional view of an end portion of the chuck according to a third embodiment of the present invention.

As can be seen in FIG. 5, the wafer- or flat glass-chuck 1 for a stepper in accordance with the third embodiment of the present invention has a vacuum hole 3a formed in an base region between two adjacent dots 2, with a communication between the vacuum hole 3a and the vacuum hole 3 of the dot 2 via a vacuum path 5.

If vacuum holes 3a are formed in some of the base regions between adjacent dots 2, a vacuum may be created via both or either of the vacuum holes 3 formed in the median portion of the dots 2 and the vacuum holes 3a formed in the base regions between dots 2. When only the vacuum created in the vacuum holes 3a formed in the base regions between the dots 2 is employed, a bank 4 should be constructed on the chuck 1 along the brink so as to prevent the destruction of the vacuum condition established across the chuck.

Although the preferred embodiments of the present invention have been disclosed for illustrative purposes, those skilled in the art will appreciate that various modifications, additions and substitutions are possible, without departing from the scope and spirit of the invention as disclosed in the accompanying claims.

## Claims

1. A wafer- or flat glass-chuck for use in a stepper, comprising a plurality of regularly spaced, embossed, frusto-pyramidal dots in a grid pattern thereon, with a vacuum hole established in a central portion of every other dots, said stepper being used in photoligraphy for fabricating a semiconductor device or an LCD or PDP..

2. The wafer- or flat glass-chuck of claim 1, wherein each of the dots has a height of 0.05 ~ 0.29 mm.

3. The wafer- or flat glass-chuck of claim 1 or 2, wherein the vacuum hole is established in every dots.

4. The wafer- or flat glass-chuck of claim 1 or 2, having vacuum holes established in some of base regions between the dots, and a bank formed along a brink thereof.

5. The wafer- or flat glass-chuck of claim 3, having vacuum holes established in some of base regions between the dots, and a bank formed along a brink thereof.
